# EUROPÄISCHE PATENTANMELDUNG

(11) **EP 1 394 559 A1**
(43) Veröffentlichungstag der Anmeldung: **03.03.2004**
(21) Anmeldenummer: 02019240.7
(22) Anmeldetag: 27.08.2002
(51) Int. Cl.: G01R 31/3185, G01R 31/02, G06F 11/16, G06F 11/20, G06F 11/267, G06F 13/00

(54) **Verfahren und Anordnung zur Erkennung und Behebung von Leitungsdefekten**

(71) Anmelder: SIEMENS AKTIENGESELLSCHAFT, 80333 München (DE)
(72) Erfinder: Peleska, Pavel, 82166 Gräfelfing (DE)

(57) **Zusammenfassung**

Verfahren und Anordnung zur Erkennung und Behebung von Leitungsdefekten

In einem fehlertoleranten System sollen einzelne oder mehrere Leitungsstörungen zwischen zwei Baugruppen (BG1, BG2), Bausteinen oder Schaltungen (IC1, IC2) nicht zu einem Ausfall des Systems führen. Darüber hinaus soll eine einzelne Leitungsstörung mit geringem Aufwand erkannt, repariert bzw. ersatzgeschaltet werden, ohne die Redundanz des Systems, dessen Funktionalität oder Leistungsfähigkeit zu beieinträchtigen. Bekannte Lösungen erreichen dies nur mittels erheblichem Schaltungsaufwand und unter Vorhaltung mehrerer zusätzlicher Leitungen (E). Beispielsweise wird für einen Bus mit einer Breite von 64 Bit ein 8 Bit-ECC benötigt, um einen Einzelbitfehler korrigieren zu können. Erfindungsgemäß wird ein Erkennungsverfahren und ein Korrekturverfahren sowie eine Schaltungsanordnung vorgesehen, die das Problem durch Ausführen einer Überprüfungsroutine auf jeder einzelnen Leitung (N, E) löst, wobei alle Fehler zuverlässig detektiert werden. Durch die zuverlässige Erkennung ist für jeden zu korrigierenden einzelnen Leitungsfehler nur eine zusätzliche Ersatzleitung (E) vorzusehen, auf die im Fehlerfall umgeschaltet wird.

## Beschreibung

In einem fehlertoleranten System, beispielsweise in einer Telekommunikationsvermittlungsanlage, sollen einzelne oder mehrere Leitungsstörungen zwischen zwei Baugruppen, Bausteinen oder Schaltungen nicht zu einem Ausfall des Systems führen. Darüber hinaus soll eine einzelne Leitungsstörung mit geringem Aufwand erkannt, repariert bzw. ersatzgeschaltet werden, ohne die Redundanz des Systems, dessen Funktionalität oder Leistungsfähigkeit zu beieinträchtigen.

Eine bekannte Möglichkeit, einzelne Leitungsstörungen zu erkennen, sieht die Verwendung von fehlerkorrigierenden Codes (ECC = error correcting code) vor. Diese Codes benötigen einen erheblichen Implementierungsaufwand (Logik) und benötigen eine signifikante Anzahl redundanter Signale. Beispielsweise wird für einen Bus mit einer Breite von 64 Bit ein 8 Bit-ECC benötigt, um einen Einzelbitfehler korrigieren zu können. Für die Auswertung des ECC ist ein signifikanter Zeitaufwand erforderlich, wodurch sich die erzielbare Performance verringert.

Es ist eine Aufgabe der vorliegenden Erfindung, ein Verfahren anzugeben, durch welches die Nachteile des Standes der Technik vermieden werden.

Diese Aufgabe wird durch ein Verfahren zur Erkennung von Störungen von Verbindungen ausgehend vom Oberbegriff des Patentanspruchs 1 durch dessen kennzeichnende Merkmale sowie durch ein Verfahren zur Behebung von Störungen von Verbindungen gemäß der Merkmale des Patentanspruchs 9 sowie durch eine Schaltungsanordnung zur Behebung von Störungen von Verbindungen gemäß des Patentanspruchs 10 gelöst.

Bevorzugte Ausführungsformen sind Gegenstand der abhängigen Ansprüche.

Gemäß der vorliegenden Erfindung wird ein Verfahren zur Erkennung von Störungen von Verbindungen, durch die ein erster Baustein und ein zweiter Baustein verbunden werden, vorgesehen. Der erste und der zweite Baustein können beispielsweise integrierte Schaltungen IC sein. Der erste und der zweite Baustein können auf einer einzigen Baugruppe oder auf verschiedenen Baugruppen angeordnet sein. Das erfindungsgemäße Verfahren zeichnet sich dadurch aus, daß nach einem das Erkennungsverfahren initiierenden Ereignis zunächst einer der Bausteine als Initiator und einer der Bausteine als Responder ermittelt wird und das Erkennungsverfahren abläuft, indem
- vom Initiator in einem ersten Schritt ein erster Wert und in einem zweiten Schritt ein zweiter Wert über die Verbindung an den Responder gesendet wird, wobei die Abfolge erster Wert -> zweiter Wert sowie der erste und zweite Wert beim Responder als eine erste erwartete Sequenz bekannt sind,
- vom Responder geprüft wird, ob die im ersten und zweiten Schritt empfangenen Werte der ersten erwarteten Sequenz entsprechen,
- falls die Überprüfung durch den Responder erfolgreich war, vom Responder in einem dritten Schritt ein dritter Wert und in einem vierten Schritt ein vierter Wert über die Verbindung an den Initiator gesendet wird, wobei die Abfolge dritter Wert -> vierter Wert sowie der dritte und vierte Wert beim Initiator als eine zweite erwartete Sequenz bekannt sind,
- falls die Überprüfung durch den Responder fehlschlägt, vom Responder im dritten Schritt der vierte Wert und im vierten Schritt der dritte Wert über die Verbindung an den Initiator gesendet und die Verbindung als fehlerhaft markiert wird,
- vom Initiator geprüft wird, ob die im dritten und vierten Schritt empfangenen Werte der zweiten erwarteten Sequenz entsprechen,
- falls die Überprüfung durch den Initiator erfolgreich war, vom Initiator in einem fünften Schritt ein fünfter Wert und in einem sechsten Schritt ein sechster Wert über die Verbindung an den Responder gesendet wird, wobei die Abfolge fünfter Wert -> sechster Wert sowie der fünfte und sechste Wert beim Responder als eine dritte erwartete Sequenz bekannt sind,
- falls die Überprüfung durch den Initiator fehlschlägt, vom Initiator im fünften Schritt der sechste Wert und im sechsten Schritt der fünfte Wert über die Verbindung an den Responder gesendet und die Verbindung als fehlerhaft markiert wird,
- vom Responder geprüft wird, ob die im fünften und sechsten Schritt empfangenen Werte der dritten erwarteten Sequenz entsprechen und die Verbindung als fehlerhaft markiert wird, wenn diese Überprüfung fehlschlägt.

Ein wichtiger Vorteil des erfindungsgemäßen Erkennungsverfahrens besteht darin, daß die Erkennung nur einen geringen Schaltungsaufwand erfordert und nur wenige Schritte, d.h. maximal 6 Schritte umfaßt. Dies ist ein bedeutender Vorteil beispielsweise gegenüber den bekannten ECC, für die eine aufwendige Zusatzlogik erforderlich ist und deren Auswertung einen signifikanten Zeitaufwand erfordern kann.

Falls es sich bei der Verbindung um einen aus mehreren binären bzw. digitalen Leitungen gebildeten Bus handelt, also um einen n-bit Bus, können durch das erfindungsgemäße Erkennungsverfahren beliebig viele gleichzeitig auftretende Bitfehler erkannt werden. Dies ist ebenfalls ein großer Vorteil gegenüber herkömmlichen ECC Verfahren, die prinzipbedingt stets nur eine begrenzte Anzahl an Fehlern erkennen und/oder korrigieren können.

Wird das Erkennungsverfahren für alle Leitungen gleichzeitig durchgeführt, werden ebenfalls nur maximal 6 Schritte benötigt, um alle Leitungen zu testen.

Erfindungsgemäß genügt aufgrund der zuverlässigen Erkennung eine einzige Ersatzleitung, um einen Einzelbitfehler zu korrigieren. Durch Vorsehen von m Ersatzleitungen können durch die vorliegenden Erfindung m fehlerhafte Leitungen behandelt werden.

Die Erfindung ist beispielsweise in einer anwendungsspezifischen integrierten Schaltung ASIC (ASIC = application specific integrated circuit) oder einer feldprogrammierbaren Gattermatrix FPGA (FPGA = field programmable gate array) oder einer anderen integrierten Schaltung IC einfach mit wenigen Gattern implementierbar. Durch die statischen Multiplexer anstelle tiefer Logik entstehen keine Performance-Nachteile. Direkt nach der Identifikation störungsbehafteter Leitungen ist ein Umschalten auf eine Ersatzleitung verzögerungsfrei möglich. Für den logischen Betrieb des Bausteins oder der Baugruppe ist die Funktion der erfindungsgemäßen Schaltungsanordnung transparent, d.h. an der eigentlichen Logik des Bausteins oder der Baugruppe sind keine Änderungen vorzunehmen, da diese lediglich die Schnittstelleneinheit betreffen.

Im folgenden wird die Erfindung als Ausführungsbeispiel anhand von 8 Figuren näher erläutert.
Figur 1A zeigt schematisch die Verbindung zwischen zwei integrierten Schaltungen mittels eines 4-bit Busses und einer Ersatzleitung,
Figur 1B zeigt schematisch die Verbindung zwischen zwei Baugruppen, die integrierte Schaltungen aufweisen, mittels eines 4-bit Busses und einer Ersatzleitung,
Figur 2 zeigt das erfindungsgemäße Erkennungsverfahren im störungsfreien Betrieb,
Figuren 3 bis 7 zeigen das erfindungsgemäße Erkennungsverfahren im störungsfreien Betrieb für verschiedene Störungen, und
Figur 8 zeigt eine integrierte Schaltung mit Schaltungsanordnung zur Erkennung und Behebung von Störungen.

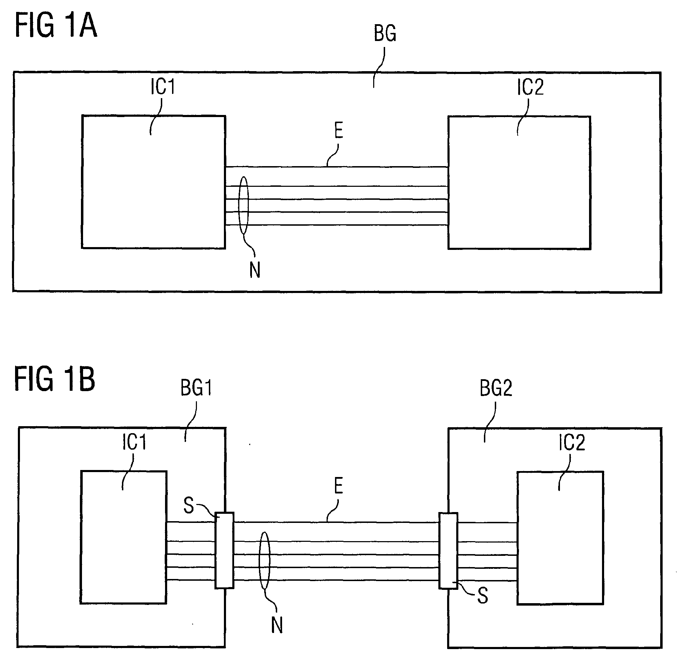

In Figuren 1A und 1B sind typische Anwendungsfälle der Erfindung beispielhaft dargestellt. Dabei zeigt Figur 1A einen ersten Baustein IC1 und einen zweiten Baustein IC2, die miteinander verbunden sind. Die Verbindung zwischen den Bausteinen IC1, IC2 wird durch vier Nutzleitungen N bzw. einen 4-bit Bus gebildet und erfindungsgemäß um eine Ersatzleitung E erweitert. Schematisch angedeutet ist, daß sich die Bausteine IC1, IC2 auf einer Baugruppe befinden. Die genannten Leitungen N, E können beispielsweise Leiterbahnen einer Leiterplatte sein. Die genannten Bausteine IC1, IC2 können beispielsweise integrierte Schaltungen IC (IC = integrated circuit) sein.

Abweichend zur Situation in Figur 1A sind in Figur 1B die Bausteine IC1, IC2 auf verschiedenen Baugruppen BG1, BG2 angeordnet. Dies erfordert beispielsweise eine zentrale Platine, auf welche die beiden Baugruppen BG1, BG2 mit Steckverbindungen S aufgesteckt werden. Die Baugruppen BG1, BG2 und die zentrale Platine weisen wiederum die vier Nutzleitungen N des 4-bit Bus und die erfindungsgemäße Ersatzleitung E auf.

Es ist offensichtlich, daß anstelle der beispielhaft beschriebenen vier Nutzleitungen N, die den 4-bit Bus bilden, eine beliebige Anzahl von Nutzleitungen eingesetzt werden kann, die einen Bus entsprechender Breite bilden. Ebenso bestehen hinsichtlich der Anzahl der Ersatzleitungen allenfalls wirtschaftliche Beschränkungen, aus Sicht der vorliegenden Erfindung ist jedoch die Zahl der Ersatzleitungen ebenfalls beliebig und kann insbesondere gemäß eines vorzugebenden Verhältnisses von Ersatzleitungen zu Nutzleitungen, z.B. eine Ersatzleitung E pro vier Nutzleitungen N, festgelegt werden, um den beim Einsatz vieler Nutzleitungen entsprechend wahrscheinlicheren Fall mehrerer gleichzeitig auftretender Störungen behandeln zu können.

Vorzugsweise handelt es sich bei der dargestellten Schnittstelle zwischen den Bausteinen IC1, IC2 in Figur 1 um ein synchrones, bidirektionales Interface. Nach einem definierten Ereignis, das zum gleichen Zeitpunkt bzw. im gleichen Taktzyklus von beiden Bausteinen IC1, IC2 erkannt wird, beginnt die Überprüfung aller Leitungen. Dabei werden in einer vorteilhaften Ausgestaltung nicht nur die Nutzleitungen N, sondern auch die Ersatzleitungen E überprüft. Das Ereignis, das die Überprüfung triggert, kann z.B. die Aktivierung oder die Deaktivierung eines Reset-Signals oder die Übertragung eines Startmusters oder die Erreichung eines Programmschrittes oder die Erreichung eines bestimmten Taktzyklus (beispielsweise jeder tausendste Taktzyklus startet die Überprüfung) sein.

Einer der Bausteine IC1, IC2 wird als Initiator und der andere Baustein IC1, IC2 als Responder agieren. Durch welche Maßnahmen die Rollenzuteilung (Initiator oder Responder) erfolgt, ist dabei von untergeordneter Bedeutung. Beispielsweise könnte es sich um eine statische, administrative Festlegung oder eine einbauplatzabhängige Festlegung oder eine Signalisierung über einen gesonderten Anschluß der Bausteine oder eine Signalisierung mittels eines Protokolls über vorhandene Anschlüsse der Bausteine handeln. In diesem Zusammenhang sei darauf hingewiesen, daß nicht notwendigerweise beide Bausteine IC1, IC2 den Aktivierungszeitpunkt erkennen müssen. Es genügt, wenn der auf eine der genannten Arten eindeutig festgelegte Initiator das Ereignis zum Start der Überprüfung erkennt und den Beginn der Überprüfung in geeigneter Weise an den Responder signalisiert. Dies kann auch mittels des vom Initiator an den Responder gesendeten Testmusters geschehen, wobei dann allerdings zusätzlich zu den im folgenden erläuterten Maßnahmen Vorkehrungen für den Fall getroffen werden müssen, daß der Responder das Testmuster aufgrund eines Fehlers nicht erkennen kann und nicht in den Überprüfungsmodus bzw. den Respondermodus übergeht.

Folgende Störungen können auftreten und werden durch das erfindungsgemäße Erkennungsverfahren zuverlässig erkannt:
- Die Leitung zwischen den Bausteinen IC1, IC2 ist unterbrochen oder kurzgeschlossen ("stuck-at fault"), beispielsweise aufgrund eines Defekts am Bonddraht, an der Lötstelle eines der Bausteine, einer Leiterbahn der Baugruppen BG, BG1, BG2, am Steckkontakt S zwischen den Baugruppen bzw. zwischen den Baugruppen und der zentralen Platine bzw. Rückwand, des Kontakts am Sockel oder einer Leiterbahn der zentralen Platine bzw. Rückwand.
- Der Sender des Interfacetreibers bzw. Interfacepuffers eines der Bausteine oder beider Bausteine IC1, IC2 liefert keinen korrekten Pegel.
- Der Empfänger des Interfacetreibers bzw. Interfacepuffers eines der Bausteine oder beider Bausteine IC1, IC2 erkennt keinen korrekten Pegel.

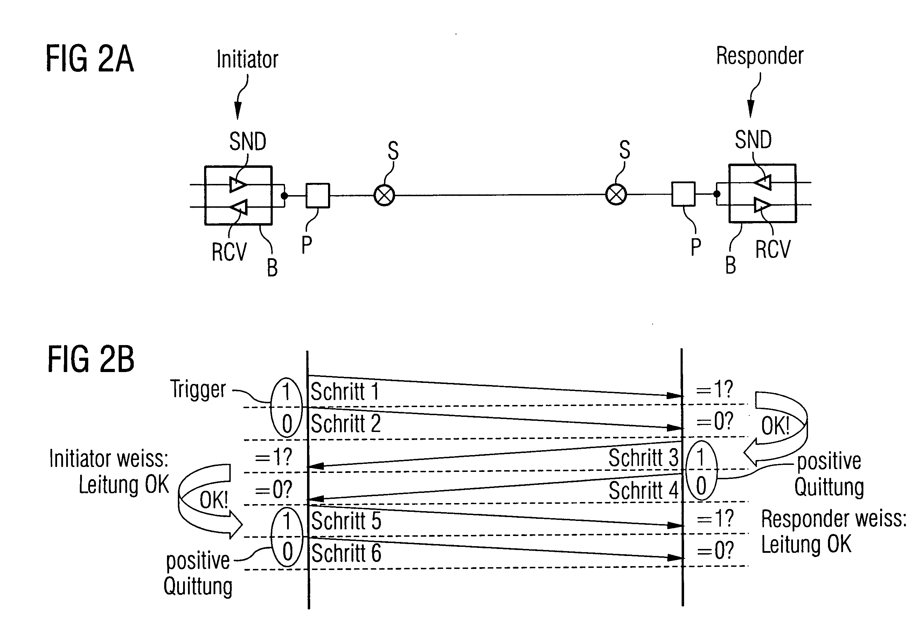

Mit Bezug auf Figur 2 wird im folgenden der störungsfreie Fall erläutert. In Figur 2A ist eine Nutzleitung N oder eine Ersatzleitung E dargestellt, die gemeinsam mit je einem Interfacepuffer oder I/O-Puffer B des Initiators und des Responders, dem jeweils mit dem I/O-Puffer B verbundenen Pin bzw. Pad bzw. Ball des jeweils den Initiator bzw. Responder enthaltenden Bausteins IC1, IC2 und mit den Steckkontakten S die zu testende Verbindung bilden. Es sei darauf hingewiesen, daß für eine einfachere Anordnung gemäß Figur 1A keine Steckkontakte auftreten. Es sei ferner darauf hingewiesen, daß die zu testende Verbindung in mehrere physikalisch getrennte Teilabschnitte aufgeteilt werden kann:
- Bonddrähte zwischen den I/O-Puffern B und den Pins/Pads/Balls P,
- Leiterbahnen auf den Baugruppen BG1, BG2, angeordnet zwischen den Pins/Pads/Balls P und den Steckkontakten S,
- Leiterbahnen auf der zentralen Platine, angeordnet zwischen den Steckkontakten S.

Schließlich sei darauf hingewiesen, daß die I/O-Puffer B jeweils einen Sender SND und einen Empfänger RCV umfassen.

Figur 2B zeigt die Abläufe des erfindungsgemäßen Erkennungsverfahrens für den störungsfreien Fall, d.h. keine der genannten Bestandteile und Teilabschnitte der Verbindung weisen Defekte auf. In Schritt 1 wird eine logische "1" vom Initiator an den Responder gesendet, und in Schritt 2 wird eine logische "0" vom Initiator an den Responder gesendet. Dieser zumindest einmalige Wechsel von "1" und "0" dient der Erkennung von stuck-at faults, d.h. Fehlern, die aus Kurzschlüssen der zu testenden Verbindung mit "1" oder "0" resultieren. Die Reihenfolge bzw. Sequenz ("1" -> "0" oder "0" -> "1") spielt dabei keine Rolle, allerdings muß diese erste Sequenz für die zu testende Verbindung beim Initiator und beim Responder bekannt sein.

Die vom Responder empfangenen Werte werden durch den Responder überprüft. Im störungsfreien Fall werden die Werte "1" und "0" sequenztreu beim Responder empfangen, woraufhin dieser in Schritt 3 eine "1" und im Schritt 4 eine "0" an den Initiator sendet. Neben der eigentlichen Funktion dieser Abfolge, die darin besteht, die Elemente der Verbindung in der anderen Richtung zu testen, dient diese zweite Sequenz dazu, dem Initiator zu signalisieren, daß die erste Sequenz störungsfrei empfangen würde (positive Quittung). Wiederum ist die Abfolge "1" -> "0" für die zweite Sequenz lediglich beispielhaft.

Die vom Initiator empfangenen Werte werden durch den Initiator überprüft. Im störungsfreien Fall werden die Werte "1" und "0" sequenztreu beim Initiator empfangen, woraufhin dieser in Schritt 5 eine "1" und im Schritt 6 eine "0" an den Responder sendet. Das sequenztreue Empfangen der Werte bedeutet für den Initiator gleichzeitig, daß die Elemente der Verbindung in beiden Richtungen störungsfrei arbeiten, der Initiator "weiß" nunmehr, daß die Verbindung fehlerfrei ist. Dies Wissen wird bei Bedarf in einem geeigneten Speicherregister vermerkt und/oder an eine Auswertelogik der integrierten Schaltung IC1, IC2, deren Bestandteil der Initiator ist, übermittelt - nicht dargestellt.

Der Initiator sendet schließlich in Schritt 5 eine "1" und im Schritt 6 eine "0" an den Responder (dritte Sequenz), um zu signalisieren, daß aus seiner "Sicht" die Verbindung störungsfrei ist (positive Quittung). Die vom Responder empfangenen Werte werden durch den Responder überprüft. Im störungsfreien Fall werden die Werte "1" und "0" sequenztreu beim Responder empfangen, wodurch dieser "weiß", daß die Verbindung in Ordnung ist. Dies Wissen wird bei Bedarf in einem geeigneten Speicherregister vermerkt und/oder an eine Auswertelogik der integrierten Schaltung IC1, IC2, deren Bestandteil der Responder ist, übermittelt - nicht dargestellt.

Die erste Sequenz (Schritte 1 und 2) kann in einer Weiterbildung der Erfindung als Trigger dienen, mit welchem der Initiator an den Responder den Beginn der Überprüfung signalisiert. Dazu kann eine längere, ansonsten im Betrieb nicht auftretende Sequenz erforderlich sein. Die zu treffenden Vorkehrungen sind dem Fachmann geläufig und werden hier nicht beschrieben.

Es liegt auf der Hand, daß längere Sequenzen eingesetzt werden können, um die Verbindung zu überprüfen und Fehler zu erkennen. Beispielsweise kann anstelle der beschriebenen Sequenz "10" eine Sequenz "101010" verwendet werden, um zusätzlich zu den detektierbaren statischen Fehlern auch dynamische Fehler, die beim raschen Pegelwechsel auftreten, erkennen zu können. Sollen nebeneinanderliegende Leiterbahnen auf Übersprechen hin untersucht werden, ist in einer Weiterbildung durch eine Steuerlogik, die das Überprüfungsverfahren steuert, eine entsprechende Koordinierung erforderlich, die sicherstellt, daß auf benachbarten Leiterbahnen verschiedene Pegel zur gleichen Zeit auftreten. Derartige Weiterbildungen existieren in großer Zahl und offenbaren sich dem Fachmann ohne Weiteres auch ohne explizite Erwähnung hierin.

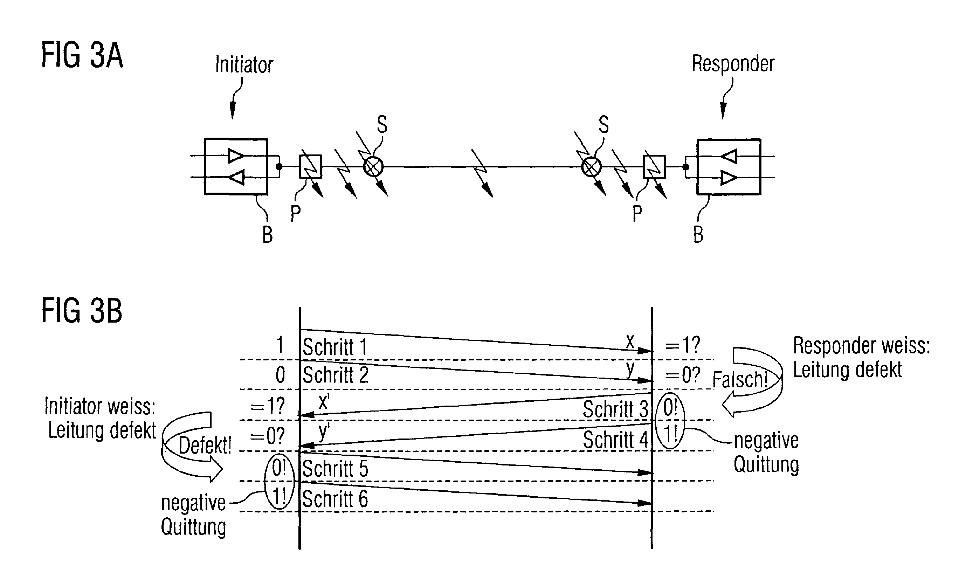

Mit Bezug auf Figur 3 wird nun der Fall einer Störung der Leitung an einem der genannten Teilabschnitte beschrieben. Figur 3A zeigt die möglichen Störungen durch Pfeile. Diese Störungen sind hinsichtlich ihrer Auswirkungen für das erfindungsgemäße Prüfverfahren äquivalent. Mögliche Störungen umfassen: defekten Bonddraht im IC, eine schadhafte Lötstelle am Pin/Pad/Ball P, einen defekten Steckerpin S oder eine unterbrochene Leitung auf der Baugruppe oder der Rückwand. Die Störung kann jeweils eine Unterbrechung bedeuten, oder einen Kurzschluß ("stuck-at fault").

Figur 3B illustriert den Ablauf des Prüfverfahrens für den Fehlerfall aus Figur 3A. Die in den Schritten 1-6 gesendeten Sequenzen entsprechen den in Zusammenhang mit Figur 2 genannten. Zur Vermeidung von Wiederholungen werden hier nur die Unterschiede zu Figur 2 erläutert.

Je nach Art des Fehlers (Unterbrechung, stuck-at-1 oder stuck-at-0) wird der Empfänger RCV des Responders keine "1" in Schritt 1 und/oder keine "0" in Schritt 2 erkennen. Daher weiß der Responder, daß ein Defekt vorliegt und sendet in den Schritten 3 und 4 eine negative Quittung, indem anstatt der Sequenz "10" die Sequenz "01" gesendet wird. Da die Leitung unterbrochen oder kurzgeschlossen ist, wird der Initiator diese negative Quittung nicht erhalten, jedoch in den Schritt 3 und 4 eine Folge eintakten, die nicht der positiven Quittung "10" entspricht. Dadurch erkennt der Initiator den Defekt dieser Leitung. Daraufhin sendet der Initiator in den Schritten 5 und 6 ebenfalls eine negative Quittung, hier die Sequenz "01" anstelle der Sequenz "10". Dies ist erforderlich, da der Initiator nicht zwischen einem tatsächlichen Leitungsdefekt und einem Defekt am Sender des Responders unterscheiden kann und in letzterem Fall der Responder informiert werden muß.

Sowohl im Initiator als auch im Empfänger wird das Wissen über den Defekt geeignet verarbeitet und/oder weitergeleitet und/oder in einem Speicher vermerkt.

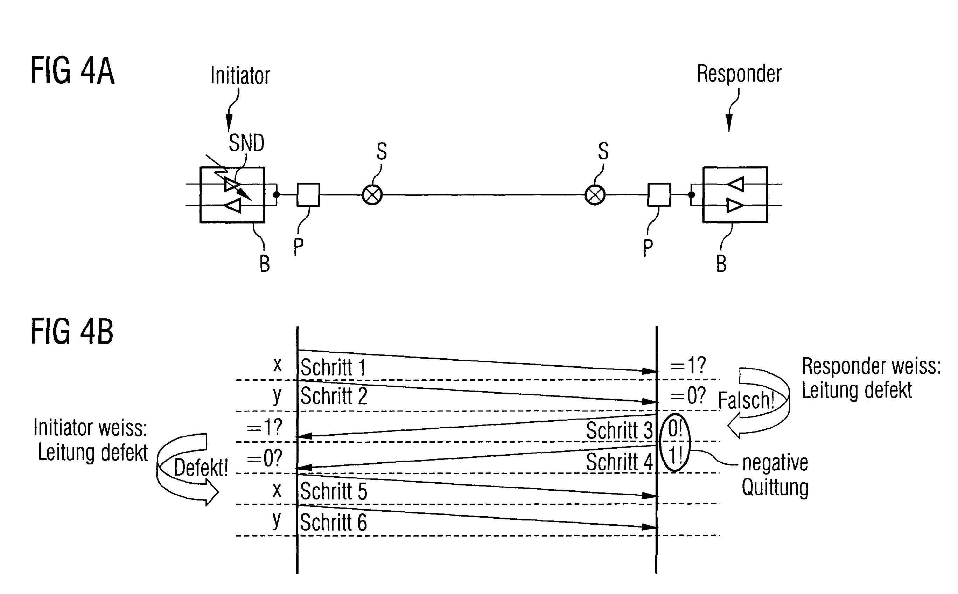

Mit Bezug auf Figur 4 wird nun der Fall einer Störung des Treiberelements bzw. Senderelements SND beim Initiator beschrieben. Figur 4A zeigt diese Störung durch einen Pfeil.

Figur 4B illustriert den Ablauf des Prüfverfahrens für den Fehlerfall aus Figur 4A. Die in den Schritten 1-6 gesendeten Sequenzen entsprechen den in Zusammenhang mit Figur 2 genannten. Wiederum werden nur die Unterschiede zu Figur 2 erläutert.

Der Empfänger des Responders wird keine "1" in Schritt 1 und/oder keine "0" in Schritt 2 erkennen. Daher "weiß" der Responder, daß ein Defekt vorliegt und sendet in den Schritten 3 und 4 eine negative Quittung, indem anstatt der Sequenz "10" die Sequenz "01" gesendet wird. Der Initiator empfängt diese negative Quittung und weiß daher, daß eine Störung vorliegt. Daraufhin versucht der Initiator, in den Schritten 5 und 6 ebenfalls eine negative Quittung zu senden, hier die Sequenz "01" anstelle der Sequenz "10". Aufgrund des defekten Treiberelements schlägt dies allerdings ebenfalls fehl. Auch in diesem Fall wissen sowohl Initiator als auch Responder, daß eine Störung vorliegt, und verarbeiten diese Information entsprechend.

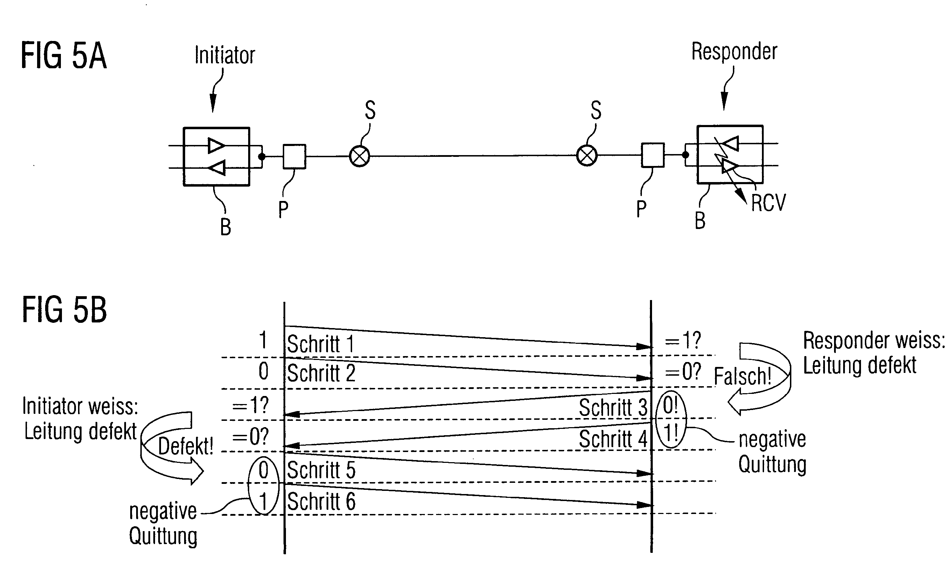

Mit Bezug auf Figur 5 wird nun der Fall einer Störung des Empfängerelements RCV beim Responder beschrieben. Figur 5A zeigt diese Störung durch einen Pfeil.

Figur 5B illustriert den Ablauf des Prüfverfahrens für den Fehlerfall aus Figur 5A. Die in den Schritten 1-6 gesendeten Sequenzen entsprechen den in Zusammenhang mit Figur 2 genannten.

Der Empfänger des Responders wird keine "1" in Schritt 1 und/oder keine "0" in Schritt 2 erkennen. Daher "weiß" der Responder, daß ein Defekt vorliegt und sendet in den Schritten 3 und 4 eine negative Quittung, indem anstatt der Sequenz "10" die Sequenz "01" gesendet wird. Der Initiator empfängt diese negative Quittung und weiß daher, daß eine Störung vorliegt. Daraufhin sendet der Initiator in den Schritten 5 und 6 ebenfalls eine negative Quittung, hier die Sequenz "01" anstelle der Sequenz "10". Aufgrund des defekten Empfängerelements wird diese allerdings ebenfalls nicht korrekt empfangen. Auch in diesem Fall wissen sowohl Initiator als auch Responder, daß eine Störung vorliegt, und verarbeiten diese Information entsprechend.

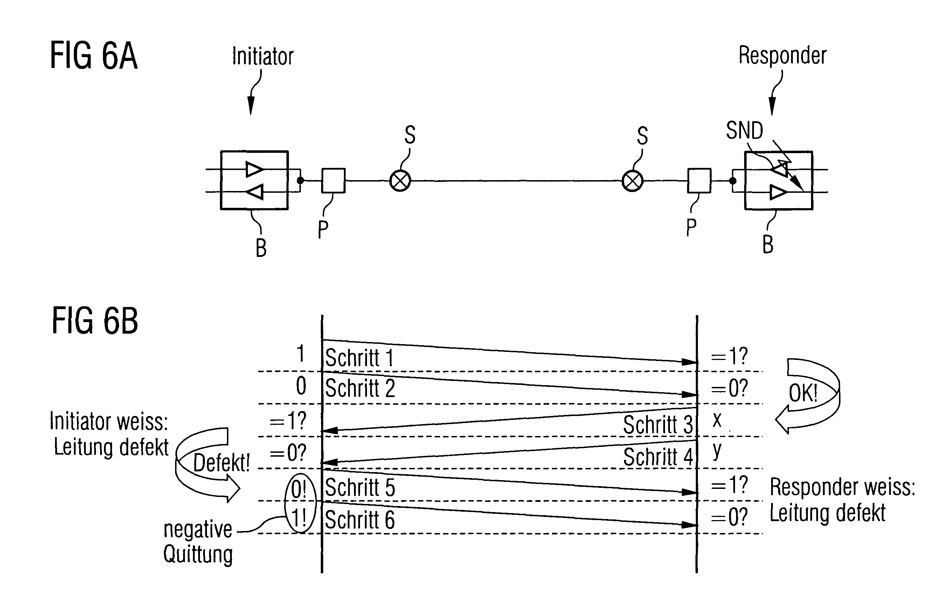

Mit Bezug auf Figur 6 wird nun der Fall einer Störung des Treiberelements bzw. Senderelements SND beim Responder beschrieben. Figur 6A zeigt diese Störung durch einen Pfeil.

Figur 6B illustriert den Ablauf des Prüfverfahrens für den Fehlerfall aus Figur 6A. Die in den Schritten 1-6 gesendeten Sequenzen entsprechen den in Zusammenhang mit Figur 2 genannten.

Der Empfänger des Responders empfängt eine "1" in Schritt 1 und eine "0" in Schritt 2. Aus Sicht des Responders ist daher die Verbindung ungestört, woraufhin der Responder in den Schritten 3 und 4 eine positive Quittung sendet, für das beschriebene Ausführungsbeispiel die Sequenz "10". Der Initiator empfängt diese positive Quittung jedoch nicht korrekt und weiß daher, daß eine Störung vorliegt. Daraufhin sendet der Initiator in den Schritten 5 und 6 eine negative Quittung, hier die Sequenz "01" anstelle der Sequenz "10". Diese wird korrekt durch den Responder empfangen, wodurch nunmehr auch der Responder "weiß", daß ein Fehler vorliegt. Auch in diesem Fall wissen sowohl Initiator als auch Responder, daß eine Störung vorliegt, und verarbeiten diese Information entsprechend.

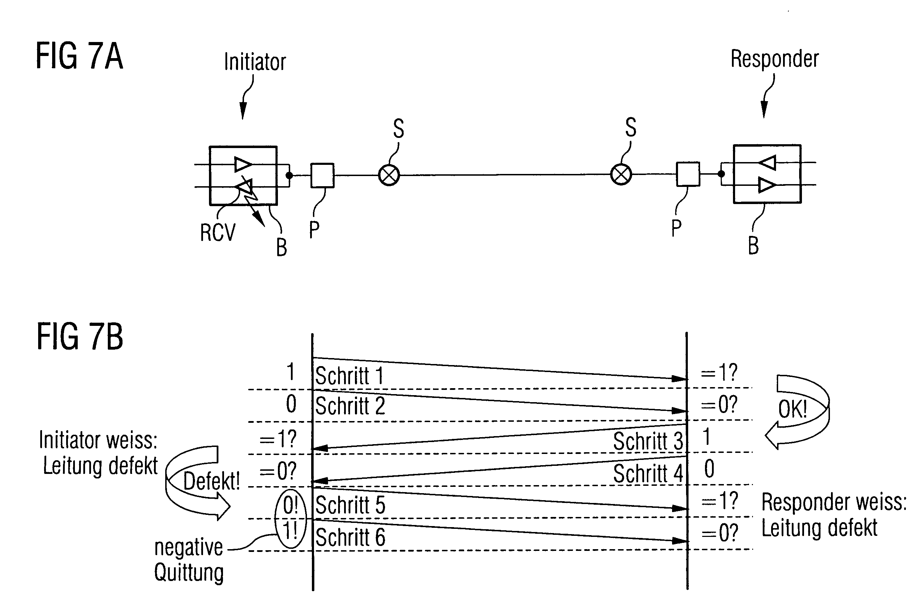

Mit Bezug auf Figur 7 wird nun der Fall einer Störung des Empfängerelements RCV beim Initiator beschrieben. Figur 7A zeigt diese Störung durch einen Pfeil.

Figur 7B illustriert den Ablauf des Prüfverfahrens für den Fehlerfall aus Figur 7A. Die in den Schritten 1-6 gesendeten Sequenzen entsprechen den in Zusammenhang mit Figur 2 genannten.

Der Empfänger des Responders empfängt eine "1" in Schritt 1 und eine "0" in Schritt 2. Aus Sicht des Responders ist daher die Verbindung ungestört, woraufhin der Responder in den Schritten 3 und 4 eine positive Quittung sendet, hier die Sequenz "10". Der Initiator empfängt diese positive Quittung jedoch nicht korrekt und weiß daher, daß eine Störung vorliegt. Daraufhin sendet der Initiator in den Schritten 5 und 6 eine negative Quittung, für das vorliegende Ausführungsbeispiel die Sequenz "01" anstelle der Sequenz "10". Diese wird korrekt durch den Responder empfangen, wodurch nunmehr auch der Responder "weiß", daß ein Fehler vorliegt. Auch in diesem Fall wissen sowohl Initiator als auch Responder, daß eine Störung vorliegt, und verarbeiten diese Information entsprechend.

In allen genannten Fällen wird ein Leitungsdefekt sowohl vom Initiator als auch dem Responder eindeutig erkannt, so daß eine Ersatzschaltung stattfinden kann. Wie viele Ersatzschaltungen möglich sind hängt, von der Anzahl der zur Verfügung stehenden Ersatzleitungen E ab.

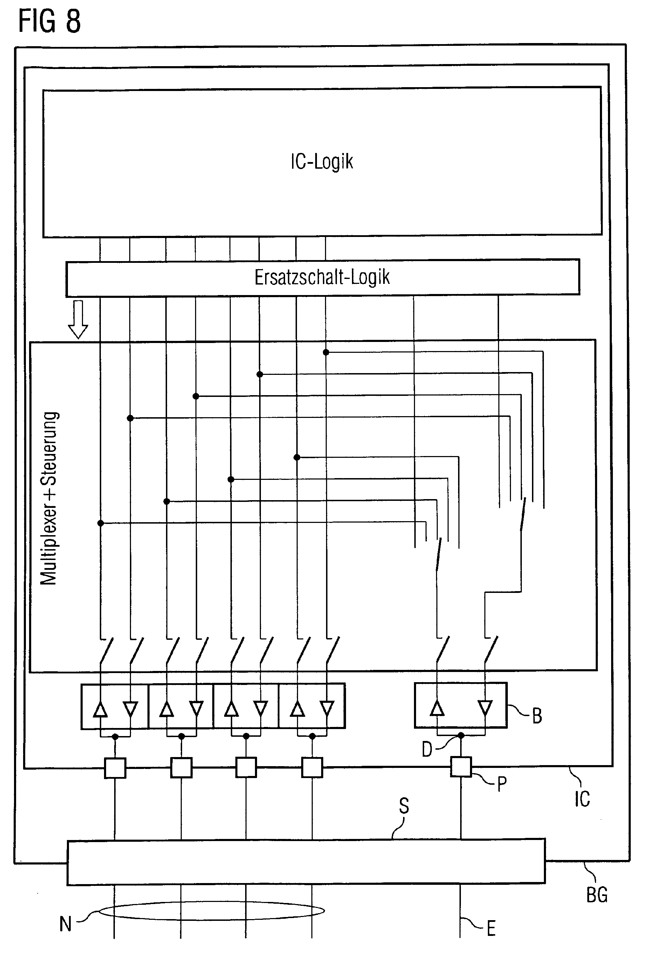

Figur 8 zeigt das Realisierungsbeispiel mit einer Ersatzleitung E für einen 4-bit Bus aus Figur 1 mit weiteren Details. In Figur 8 wird eine Schaltungsanordnung offenbart, die eine Ersatzschaltung ansprechend auf das Erkennen eines Leitungsdefektes vornehmen kann. Dargestellt sind ein Multiplexer und eine Steuerung für die Versorgung und Auswahl der Ersatzleitung, sowie eine Ersatzschalt-Logik, die das im Zusammenhang mit Figuren 1-7 beschriebene Verfahren implementiert und anschließend den Multiplexer steuert. Die übrige IC-Logik ist vom diesem Verfahren nicht betroffen, so daß ein geringer Implementierungsaufwand entsteht.

In alternativen Ausführungsbeispielen können andere Verfahren zur Erkennung von Leitungsdefekten mit der Schaltungsanordnung aus Figur 8 vorteilhaft eingesetzt werden.

Vorteilhaft werden die durch das Fehlererkennungs- und Umschalteverfahren sowohl die Nutzleitungen N der zu verbessernden Verbindung als auch deren Ersatzleitungen E umfaßt, da somit sichergestellt wird, daß einerseits beim Auftreten eines Defekts auf einer Ersatzleitung auf eine andere Ersatzleitung umgeschaltet wird und andererseits das Umschalten von einer defekten Nutzleitung auf eine ebenfalls defekte Ersatzleitung vermieden wird.

Liegen mehr Defekte als Ersatzleitungen vor, ist die Verbindung irreparabel ausgefallen, und es können durch die Steuerlogik entsprechende Aktionen ausgelöst werden, z.B. Signalisierung an einen zentralen Alarmbaustein der Baugruppe, Ausgabe eines Signals an einem Diagnose-Pin, Umschaltung auf eine redundante Baugruppe bzw. ein redundantes System etc. Derartige Fehlerbehandlungsmechanismen für selbstdiagnostizierte Ausfälle sind in der Technik wohlbekannt und im Zusammenhang mit dieser Erfindung anwendbar.

Wie bereits angedeutet, können in einer Weiterbildung Fehlerfälle detektiert werden, die bei unmittelbar benachbarten Pins eines Bausteins IC1, IC2 auftreten können. Die Pins sind dabei die üblicherweise an benachbarte Leitungen der Leiterplatte, der Rückwand und/oder Pins des Steckers angeschlossen. Dazu wird bei jedem zweiten Pin das obige Verfahren mit einem invertierten Pegel angewandt, um ggf. auch Kurzschlüsse zwischen benachbarten Pins oder Leitungen zu erkennen.

Ein Schritt 1-6 kann einem Takt des synchronen Interfaces entsprechen, somit wäre die Überprüfung und Ersatzschaltung bereits nach 6 Takten erfolgt. Je nach verwendeter Sender/Empfänger-Technologie, beispielsweise bei CMOS Totem-Pole, kann es erforderlich sein, zwischen Schritt 2 und Schritt 3 sowie zwischen Schritt 4 und Schritt 5 einen Leertakt, einen sogenannten "Turnaround Cycle", einzufügen, um Treiberkonflikten vorzubeugen. In diesem Fall erfordert das Verfahren insgesamt 8 Takte. Bei einem GTL-Interface beispielsweise sind diese Turnaround-Cycles nicht erforderlich, nach 6 Takten ist hier das Überprüfungsverfahren durchlaufen.

Das oben beschriebene Verfahren kann, wie bereits erläutert, zum Zwecke der Erhöhung der Fehlererkennungssicherheit erweitert werden, indem der Trigger (Schritte 1 und 2) nicht nur eine '10' Sequenz ist, sondern diese beispielsweise durch dreifache Wiederholung der Schritte 1 und 2 dreifach gesendet und erwartet wird, also als '101010'. Die gleiche '101010' Folge kann die positive Quittung darstellen, eine '010101' Folge entsprechend die negative Quittung. Dadurch können auch dynamische Defekte erfaßt werden.

Es ist ferner möglich, die jeweils einander zugeordneten Schritte (1 und 2, 3 und 4 sowie 5 und 6) zur Bildung beliebiger Sequenzen in beliebiger Reihenfolge zu wiederholen. Beispielsweise läßt sich, falls in Schritt 1 '1' und in Schritt 2 '0' verwendet wird, die Sequenz '100110' darstellen als Schrittfolge 1-2-2-1-1-2. Die Länge der Sequenzen der Schritte 1-2, 3-4 und 5-6 ist dabei vorzugsweise gleich, kann aber auch verschieden sein.

## Patentansprüche

1. Verfahren zur Erkennung von Störungen von Verbindungen (N, E), durch die ein erster Baustein (IC1) und ein zweiter Baustein (IC2) verbunden werden,
**dadurch gekennzeichnet,**
**daß** nach einem das Erkennungsverfahren initiierenden Ereignis zunächst einer der Bausteine (IC1, IC2) als Initiator und einer der Bausteine als Responder ermittelt wird und das Erkennungsverfahren abläuft, indem
- vom Initiator in einem ersten Schritt ein erster Wert und in einem zweiten Schritt ein zweiter Wert über die Verbindung an den Responder gesendet wird, wobei die Abfolge erster Wert -> zweiter Wert sowie der erste und zweite Wert beim Responder als eine erste erwartete Sequenz bekannt sind,
- vom Responder geprüft wird, ob die im ersten und zweiten Schritt empfangenen Werte der ersten erwarteten Sequenz entsprechen,
- falls die Überprüfung durch den Responder erfolgreich war, vom Responder in einem dritten Schritt ein dritter Wert und in einem vierten Schritt ein vierter Wert über die Verbindung an den Initiator gesendet wird, wobei die Abfolge dritter Wert -> vierter Wert sowie der dritte und vierte Wert beim Initiator als eine zweite erwartete Sequenz bekannt sind,
- falls die Überprüfung durch den Responder fehlschlägt, vom Responder im dritten Schritt der vierte Wert und im vierten Schritt der dritte Wert über die Verbindung an den Initiator gesendet und die Verbindung als fehlerhaft markiert wird,
- vom Initiator geprüft wird, ob die im dritten und vierten Schritt empfangenen Werte der zweiten erwarteten Sequenz entsprechen,
- falls die Überprüfung durch den Initiator erfolgreich war, vom Initiator in einem fünften Schritt ein fünfter Wert und in einem sechsten Schritt ein sechster Wert über die Verbindung an den Responder gesendet wird, wobei die Abfolge fünfter Wert -> sechster Wert sowie der fünfte und sechste Wert beim Responder als eine dritte erwartete Sequenz bekannt sind,
- falls die Überprüfung durch den Initiator fehlschlägt, vom Initiator im fünften Schritt der sechste Wert und im sechsten Schritt der fünfte Wert über die Verbindung an den Responder gesendet und die Verbindung als fehlerhaft markiert wird,
- vom Responder geprüft wird, ob die im fünften und sechsten Schritt empfangenen Werte der dritten erwarteten Sequenz entsprechen und die Verbindung als fehlerhaft markiert wird, wenn diese Überprüfung fehlschlägt.

2. Verfahren nach Anspruch 1,
**dadurch gekennzeichnet,**
**daß** der erste und der zweite Wert sowie der dritte und der vierte Wert sowie der fünfte und der sechste Wert jeweils paarweise verschieden sind.

3. Verfahren nach einem der Ansprüche 1 oder 2,
**dadurch gekennzeichnet,**
- **daß** der erste und der zweite Schritt zumindest einmal in beliebiger Reihenfolge nach dem zweiten Schritt wiederholt werden, wobei sich dann die erste erwartete Sequenz entsprechend erweitert,
- **daß** der dritte und der vierte Schritt zumindest einmal in beliebiger Reihenfolge nach dem vierten Schritt wiederholt werden, wobei sich dann die zweite erwartete Sequenz entsprechend erweitert, und
- **daß** der fünfte und der sechste Schritt zumindest einmal in beliebiger Reihenfolge nach dem sechsten Schritt wiederholt werden, wobei sich dann die dritte erwartete Sequenz entsprechend erweitert.

4. Verfahren nach einem der Ansprüche 1 bis 3,
**dadurch gekennzeichnet,**
**daß** die Ermittlung eines der Bausteine (IC1, IC2) als Initiator und eines der Bausteine als Responder durch statische, administrative Festlegung oder durch einbauplatzabhängige Festlegung oder durch Signalisierung über einen gesonderten Anschluß der Bausteine oder durch Signalisierung mittels eines Protokolls über vorhandene Anschlüsse der Bausteine vorgenommen wird.

5. Verfahren nach einem der Ansprüche 1 bis 4,
**dadurch gekennzeichnet,**
**daß** für eine als fehlerhaft markierte Verbindung (N, E) durch eine Steuerlogik, die das Erkennungsverfahren steuert, eine vorhandene Ersatzverbindung (E) aktiviert wird.

6. Verfahren nach einem der Ansprüche 1 bis 5,
**dadurch gekennzeichnet,**
**daß** zum Erkennen von Störungen auf binären Verbindungen für den ersten, den dritten und den fünften Wert jeweils einer der Werte 0 oder 1 gewählt wird und der zweite Wert aus der logischen Invertierung des ersten Wertes, der vierte Wert aus der logischen Invertierung des dritten Wertes und der sechste Wert aus der logischen Invertierung des fünften Wertes ermittelt wird.

7. Verfahren nach Anspruch 6,
**dadurch gekennzeichnet,**
**daß** für Busverbindungen mit einer Breite von n Bit, die durch n binäre Verbindungen (N) gebildet werden, das Erkennungsverfahren für jede der n binären Verbindungen (N) durchgeführt wird.

8. Verfahren nach Anspruch 7,
**dadurch gekennzeichnet,**
**daß** für die genannten Busverbindungen mit einer Breite von n Bit, die durch die n binären Verbindungen (N) gebildet werden, mindestens eine binäre Ersatzverbindung (E) vorgesehen wird, die aktiviert wird, falls eine der n binären Verbindungen (N) als fehlerhaft markiert ist.

9. Verfahren zur Behebung von Störungen von Verbindungen (N, E) zwischen digitalen Bausteinen, wobei die Verbindung aus einer ersten Gruppe aktiver Verbindungsleitungen (N) gebildet wird, demgemäß eine zweite Gruppe inaktiver Verbindungsleitungen (E) vorgesehen wird, wobei gesteuert durch eine Steuerlogik in Zusammenwirkung mit einer Multiplexereinrichtung eine inaktive Verbindungsleitung (E) der zweiten Gruppe aktiviert und eine bis zu diesem Zeitpunkt aktive Verbindungsleitung (N) deaktiviert wird, falls die aktive Verbindungsleitung (N) durch die Steuerlogik als fehlerhaft ermittelt wird.

10. Schaltungsanordnung zur Behebung von Störungen von Verbindungen (N, E) zwischen digitalen Bausteinen mit einer Steuerlogik zum Erkennen anordnungsinterner und anordnungsexterner Störungen von Ein/Ausgabeverbindungen (N, E) und Multiplexermitteln zum Umschalten der Datenübertragung gestörter aktiver Ein/Ausgabeverbindungen auf ungestörte inaktive Ein/Ausgabeverbindungen (E).

11. Schaltungsanordnung nach Anspruch 10,
**dadurch gekennzeichnet,**
**daß** die Steuerlogik Mittel zum Umsetzen des Verfahrens nach einem der Ansprüche 1 bis 8 aufweist.

12. Schaltungsanordnung nach einem der Ansprüche 10 oder 11,
**dadurch gekennzeichnet,**
**daß** die Schaltungsanordnung Bestandteil einer integrierten Schaltung (IC) ist.
